Europäisches Patentamt

European Patent Office

Office européen des brevets

(19)

(11) Numéro de publication: **0 033 429**

A2

(12) # DEMANDE DE BREVET EUROPEEN

(21) Numéro de dépôt: **80401810.9**

(22) Date de dépôt: **17.12.80**

(51) Int. Cl.³: **H 01 L 31/06**

(30) Priorité: **01.02.80 FR 8002249**

(43) Date de publication de la demande:
**12.08.81 Bulletin 81/32**

(84) Etats contractants désignés:
**CH DE GB IT LI NL SE**

(71) Demandeur: **THOMSON-CSF**
**173, Boulevard Haussmann**
**F-75360 Paris Cedex 08(FR)**

(72) Inventeur: **de Cremoux, Baudouin**
**THOMSON-CSF SCPI 173, Bld Haussmann**
**F-75360 Paris Cedex 08(FR)**

(72) Inventeur: **Poulain, Pierre**
**THOMSON-CSF SCPI 173, Bld Haussmann**
**F-75360 Paris Cedex 08(FR)**

(72) Inventeur: **Sol, Nicole**
**THOMSON-CSF SCPI 173, Bld Haussmann**
**F-75360 Paris Cedex 08(FR)**

(74) Mandataire: **Giraud, Pierre et al,**
**"THOMSON-CSF" 173, bld Haussmann**
**F-75360 Paris Cedex 08(FR)**

(54) **Cellule photovoltaique applicable à la fabrication de piles solaires.**

(57) L'invention vise à l'obtention de cellules photovoltaïques à bas prix de revient, notamment en utilisant une couche aussi mince que possible de composés semiconducteurs capables de présenter l'effet photovoltaïque, et cela sous la forme polycristalline.

A cet effet, sur une feuille de molybdène (1), on dépose une couche auxiliaire (2) de germanium polycristallin pour faciliter les dépôts ultérieurs, puis une couche polycristalline intermédiaire (30) d'arséniure de gallium et d'aluminium et une couche active (3) d'arséniure de gallium polycristallin, la présence de la couche intermédiaire à bande interdite plus large que celle de la couche active tendant à compenser l'effet, sur le rendement, de la faible épaisseur de la couche active.

Application aux piles solaires à faible coût.

FIG.3

(GaAlAs)

GaAs (n) — 4, 3
Ge (n) — 30, 2
Mo — 1

5

EP 0 033 429 A2

1

# CELLULE PHOTOVOLTAÏQUE APPLICABLE A LA FABRICATION DE PILES SOLAIRES

L'invention concerne une cellule photovoltaïque applicable à la fabrication de piles solaires.

Dans le domaine des piles solaires, on cherche à fabriquer des dispositifs de faible prix de revient présentant toutefois un rendement acceptable de conversion. En pratique on réalise un compromis entre des exigences en partie contradictoires.

On sait obtenir des rendements de conversion relativement élevés, de l'ordre de 20% en utilisant comme couche active un matériau monocristallin constitué par un semiconducteur du type III-V comme Ga As ou In P. Cette utilisation conduit à des coûts élevés et convient plutôt aux générateurs solaires utilisant des moyens optiques de concentration du flux solaire qu'aux utilisations courantes.

Plus récemment on a proposé d'abaisser le prix de revient en utilisant des couches minces polycristallines déposées sur des supports de faible coût en graphite ou en molybdène.

On a décrit notamment une solution dans laquelle on interpose entre le support et la couche active en arséniure de gallium polycristallin une couche de germanium polycristallin qui a pour effet d'augmenter la taille des grains de la couche active polycristalline déposée par épitaxie sur le germanium. Avec un tel support composite (molybdène revêtu de germanium) on observe des rendements de conversion de l'ordre de 5 à 6%. Le germanium pourrait être remplacé par un autre matériau de maille cristalline assez voisine de celle du matériau de la couche active pour permettre l'épitaxie.

Le but de l'invention est d'obtenir :

- soit une amélioration du rendement à coût égal en matière première et d'autres composantes du prix de revient ;

- soit une diminution du prix de revient de la cellule, notamment par la diminution du coût en matière première, et cela à rendement égal.

La cellule photovoltaïque selon l'invention est du type comportant un contact ohmique, une couche semiconductrice active très mince, dont l'épaisseur est de l'ordre de la longueur de diffusion du matériau, capable d'absorber le rayonnement lumineux, une couche semiconductrice ou métallique :

- formant une jonction redresseuse avec la couche active ;

- de façon que l'ensemble puisse présenter l'effet photovoltaïque.

Elle est principalement caractérisée en ce qu'elle comporte en outre, entre la couche active et la couche semiconductrice ou métallique une couche intermédiaire beaucoup plus mince que la couche active et formée d'un composé semiconducteur à largeur de bande interdite supérieure à celle de la couche active, les paramètres cristallins des matériaux de la couche intermédiaire et de la couche active étant égaux à moins de 5 pour 1000. Selon une autre caractéristique, la couche active est en arséniure de gallium polycristallin et la couche intermédiaire est en alliage polycristallin de formule $Ga_{1-x} Al_x As$ avec $0,3 \leq x \leq 0,5$.

L'invention sera mieux comprise, et d'autres caractéristiques apparaîtront, au moyen de la description qui suit, et des dessins qui l'accompagnent, parmi lesquels :

- la figure 1 est un exemple de cellule photovoltaïque tiré de l'art connu ;

- la figure 2 est un graphique explicatif ;

- les figures 3 et 4 représentent en coupe schématique deux réalisations de l'invention.

A l'origine de l'invention on trouve des considérations de rendement. Or on doit distinguer nettement rendement de conversion et rendement quantique. Le premier est le rendement énergétique global dont il a été question dans les considérations qui précèdent. Le rendement quantique, qui n'intervient que pour une part seulement, dans le rendement énergétique total, est défini par le rapport entre le nombre de porteurs de charges recueillis sur les électrodes de la cellule photovoltaïque d'une part, et, d'autre part, le nombre de photons absorbés par le matériau semiconducteur, chacun d'eux donnant naissance à une paire électron-trou. On sait que, parmi les facteurs de diminution de ce rendement quantique on doit compter principalement la disparition de porteurs de charges du type dit' minoritaire (électrons ou trous suivant que le matériau semiconducteur est de type p ou n) avant qu'ils aient été recueillis par l'électrode intéressée pour concourir à la création de courant électrique. En effet :

1) Dans le cas d'une couche active en matériau de type n, les électrons créés par l'effet photovoltaïque, majoritaires, participent sans exception à la création de courant. Par contre les trous, minoritaires, disparaissent en partie pour plusieurs raisons :

a - leur durée de vie est limitée : il existe une longueur de diffusion moyenne de ces porteurs, qui, pour un matériau de composition et de qualité cristalline donné, est fonction de la vitesse propre (mobilité) du porteur dans le milieu considéré et de probabilité de sa recombinaison dans ce milieu ;

b - on constate une absorption des trous par le contact ohmique, que celui-ci soit constitué par un métal ou par une couche semiconductrice.

2) Dans le cas d'une couche active en matériau de type p, les phénomènes sont analogues, en permutant toutefois trous et électrons, avec la différence que la mobilité des électrons est bien supérieure à celle

4

des trous, ce qui donne une longueur de diffusion environ quatre fois plus grande, toutes choses étant égales par ailleurs, et améliore notablement le rendement quantique.

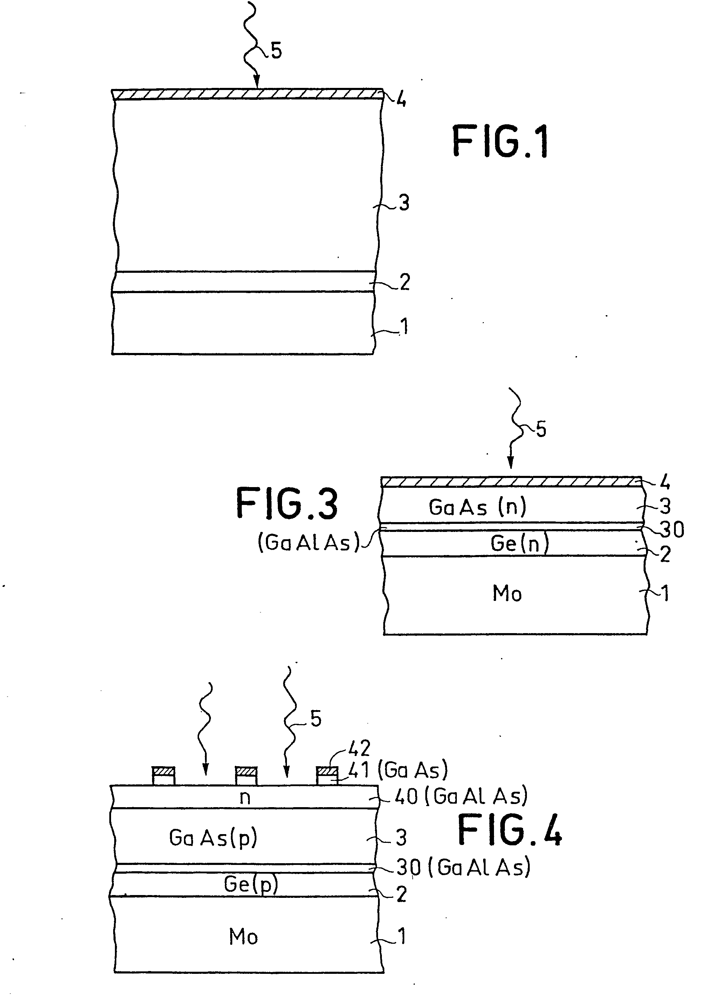

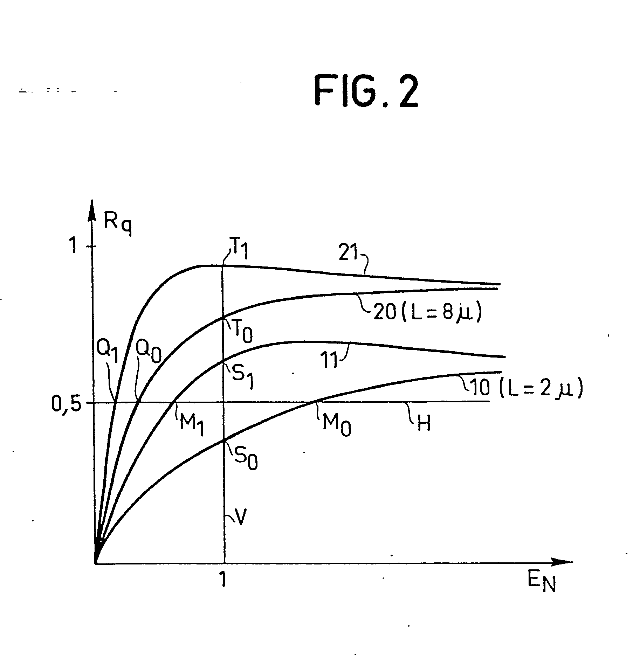

On a calculé que pour une épaisseur donnée de la couche active, la valeur du rendement quantique est principalement fonction de la longueur de diffusion. Les résultats de ces calculs, assez complexes, sont illustrés ci-après par les courbes 10 et 20 de la figure 2 relatives à une cellule photovoltaïque connue représentée figure 1, mais par ailleurs très générales. La figure 2 comporte par ailleurs d'autres courbes 11 et 21 relatives à l'invention.

Figure 1, on a représenté, en coupe schématique partielle, une cellule photovoltaïque en arséniure de gallium sur support composite molybdène-germanium. Sur une feuille de molybdène 1 servant de support mécanique et d'électrode pour l'ensemble de la cellule, on a déposé, par une méthode connue, une couche 2 polycristalline de germanium de type n et d'épaisseur égale à quelques microns.

Sur la couche 2, on a déposé par épitaxie une couche 3, beaucoup plus épaisse, en arséniure de gallium polycristalline (couche active).

Enfin une couche métallique 4, par exemple d'or, a été déposée par évaporation sous vide sur la couche 3. Elle est assez mince pour être transparente aux radiations solaires et sert d'électrode complémentaire de l'électrode 1.

Figure 2, on a porté en abscisses l'épaisseur $E_N$ ou épaisseur normalisée de la couche active ; on a :

$$E_N = E/L$$

où E est l'épaisseur de la couche active et L la longueur de diffusion exprimées dans la même unité.

En ordonnées on a porté le rendement quantique $R_q$.

On a tracé les courbes 10 et 20 relatives à deux valeurs de L, à savoir respectivement deux et huit microns, pour une cellule classique. Les courbes sont nettement distinctes, bien qu'on ait porté en abscisses E/L, en raison de la non-linéarité de $R_q$ en fonction de L. Les courbes 11 et 21 sont respectivement relatives aux mêmes valeurs de L pour des cellules conformes à une réalisation de l'invention, par exemple celle de la figure 3.

On peut voir que :

a) à $R_q$ égal, la droite H coupe les courbes en $M_o$, $M_1$, $Q_o$, $Q_1$ montrant que les épaisseurs sont plus faibles dans le cas de l'invention (courbes 11 et 21) que dans le cas de réalisations connues (courbes 10 et 20) ;

b) à épaisseur normalisée égale, la droite V coupe les courbes en $S_o$, $S_1$, $T_o$ et $T_1$ en montrant que $R_q$ est plus grand dans le cas de l'invention.

On constate notamment que l'on peut doubler le rendement dans le cas de l'invention lorsque l'épaisseur de la couche active est très faible ($E_N$ de l'ordre de l'unité).

Dans une première réalisation de l'invention, représentée figure 3, on retrouve le support composite de la cellule photovoltaïque de la figure 1, comportant une plaque 1 de molybdène recouverte d'une couche 2 de germanium polycristallin de type n. Cette couche peut être obtenue en utilisant une des trois méthodes ci-après :

a) le dépôt , en phase vapeur, dans un réacteur du type "appareil d'épitaxie", en décomposant un composé volatil tel que le tétrachlorure de germanium ;

b) la pulvérisation cathodique de germanium ;

c) l'évaporation sous vide de germanium avec condensation sur le support.

Sur la couche 2 on a déposé, par épitaxies successives :

- une couche polycristalline 30 en $Ga_{1-x} Al_x As$ avec

6

$0{,}3 \leq x \leq 0{,}5$

- une couche 3 en Ga As polycristallin.

On sait que l'accord de maille des réseaux cristallins des monocristaux de Ga As et de $Ga_{1-x} Al_x$ As est réalisé quel que soit x à 1/2000 près, ce qui est favorable à l'obtention d'un rendement satisfaisant de la cellule.

La couche 30 est de type n, dopée de manière à présenter une concentration de porteurs libres supérieure à $10^{17}$ cm$^{-3}$ ; son épaisseur est d'environ 0,1 micron.

La couche 3 est également du type n, mais avec une concentration comprise entre $10^{16}$ et $10^{17}$ cm$^{-3}$ ; son épaisseur est de 1 à 2 microns.

Ces deux couches sont déposées de préférence en utilisant la méthode, maintenant classique, de décomposition de composés organométalliques de gallium et d'aluminium, dans un appareil d'épitaxie ou différentes couches, de compositions différentes, sont déposées en faisant varier la composition des gaz introduits dans l'appareil, sans retirer l'échantillon à traiter.

Comme dans le cas de la figure 1, on a déposé une électrode formée d'une couche d'or d'une centaine d'angströms d'épaisseur, par une méthode classique de métallisation sous vide. On sait que dans ces conditions, on obtient, sur GaAs, une diode de type Schottky.

Dans une deuxième réalisation de l'invention, représentée figure 4, on retrouve un support composite analogue à celui de la première réalisation, avec toutefois une couche 2 de germanium dopée de manière à être de type p. La couche intermédiaire 30 en $Ga_{1-x} Al_x$ As est de même épaisseur mais dopée de type p avec une concentration de porteurs libres supérieure à $10^{17}$ cm$^{-3}$. La valeur de x est identique à celle de la première réalisation.

La couche 3 en GaAs est de type p avec une concentration de porteurs libres comprise entre $10^{17}$ et $10^{18}$

$cm^{-3}$. Son épaisseur peut varier entre 1 et 4 microns.

Une couche 40 d'épaisseur 0,1 et 1 micron est déposée par une opération supplémentaire d'épitaxie dans le même appareil, de manière à obtenir un dépôt polycristallin de :

$$Ga_{1-y} Al_y As$$
avec $0,5 \leq y < 1$

le dopage étant de type n et poussé jusqu'à la concentration de $10^{18}$ $cm^{-3}$ au minimum en porteurs libres.

On peut faire varier le paramètre y de la couche 40 de manière à avoir une largeur de bande interdite de largeur croissante, c'est à dire faire croitre y progressivement, par exemple de 0,2 à 0,8 au cours de l'épitaxie de la couche 40.

Cette couche 40 forme avec la couche 3 une jonction np indispensable à la constitution de la cellule.

Dans cette réalisation on ne peut déposer directement la couche d'or sur la couche 40 en raison du mauvais contact ohmique qui en résulterait, alors que l'on désire en ce cas réaliser un véritable contact ohmique.

On dépose une couche 41 de GaAs que l'on évide ensuite en forme de grille, ainsi qu'il est représenté figure 4, pour éviter l'absorption d'une partie des photons incidents par GaAs. On obtient cette grille de façon classique par attaque chimique après masquage préalable.

Enfin une couche 42 de métal est déposée sur la grille 41 en utilisant de façon également classique un masque identique au précédent.

Pour expliquer le fonctionnement théorique des cellules photovoltaïques selon l'invention, il est nécessaire d'avoir recours à des câlculs complexes. Pour des longueurs de diffusion de 2 et 8 microns, correspondant sensiblement aux cas des trous et des électrons dans des matériaux polycristallins de qualités équivalentes, relativement bonnes, par exemple pour des matériaux

8

polycristallins à gros grains, les calculs conduisent à des courbes proches des courbes 11 et 21 de la figure 2. Ces courbes, on l'a vu, mettent en évidence les avantages de l'invention par rapport aux solutions antérieures.

Si l'on veut donner une explication qualitative du phénomène dans le cas de la couche intermédiaire qui constitue la caractéristique principale de l'invention, on dira que la présence de la couche 30 (figure 3 ou 4) introduit dans le tracé des limites de la bande interdite une bosse qui joue le rôle analogue à celui d'une colline de potentiel, pour empêcher les porteurs minoritaires de tomber dans un puits de potentiel situé du côté du support de la cellule, et d'être ainsi perdus pour la création de courant électrique.

D'autres matériaux semiconducteurs peuvent être utilisés dans le cadre de l'invention :

- dans le cas de GaAs, un autre matériau ternaire ou un matériau quaternaire tel que Ga In As P ;

- dans le cas d'In P un composé quaternaire comportant des proportions variables d'In P et, par exemple, de Cd S.

9

## REVENDICATIONS

1. Cellule photovoltaïque, du type comportant un contact ohmique (4), une couche semiconductrice active (3) dont l'épaisseur est de l'ordre de la longueur de diffusion du matériau semiconducteur, une couche (2) semiconductrice ou métallique formant une jonction redresseuse avec la couche active (3) de façon que l'ensemble puisse présenter l'effet photovoltaïque, caractérisée en ce qu'elle comporte en outre, entre la couche active (3) et la couche (2) semiconductrice ou métallique une couche intermédiaire beaucoup plus mince que la couche active et formée d'un composé semiconducteur à largeur de bande interdite supérieure à celle de la couche active, les paramètres cristallins des matériaux de la couche intermédiaire et de la couche active étant égaux à moins de 5 pour 1000.

2. Cellule photovoltaïque selon la revendication 1, caractérisée en ce que la couche active (3) est en arséniure de gallium polycristallin et la couche intermédiaire est en alliage polycristallin de formule $Ga_{1-x} Al_x As$ avec $0,3 \leq x \leq 0,5$.

3. Cellule photovoltaïque selon la revendication 1, caractérisée en ce qu'elle comporte une feuille métallique (1) recouverte d'une couche (2) de germanium polycristallin contiguë à la couche intermédiaire (30), l'épaisseur de cette couche intermédiaire étant de l'ordre du dixième de micron

4. Cellule photovoltaïque selon la revendication 3, caractérisée en ce que le germanium, la couche active (3) et la couche intermédiaire (30) présentent une conductivité de type n, la couche active étant recouverte d'une couche (4) de métal bon conducteur d'épaisseur assez faible pour être transparente à la lumière et de nature propre à la formation d'un contact Schottky.

5. Cellule photovoltaïque selon la revendication 3, caractérisée en ce que le germanium, la couche active (3) et la couche intermédiaire (30) présentent une conductibilité de type p, et qu'une couche semiconductrice (40) de type de conductivité opposé à celui de la couche active (3) et de bande interdite plus large que celle de la couche active (3) est déposée sur la couche active (3).

6. Cellule photovoltaïque selon la revendication 3, caractérisée en ce que la concentration du dopage n de la couche active (3) d'arséniure de gallium est de l'ordre de $10^{16}$ à $10^{17}$ $cm^{-3}$ et la concentration du dopage n de la couche intermédiaire (30) est supérieure à $10^{17}$ $cm^{-3}$.

7. Cellule photovoltaïque selon la revendication 5, caractérisée en ce que la couche active (3) est en arséniure de gallium dopé p, la couche intermédiaire (30) est en composé semiconducteur dopé p de formule :

$$Ga_{1-x} Al_x As$$

avec :

$$0,3 \leq x \leq 0,5$$

et la couche (40) de type n est en composé semiconducteur de formule :

$$Ga_{1-y} Al_x As$$

avec :

$$0,5 \leq y < 1$$

8. Cellule photovoltaïque selon la revendication 7, caractérisée en ce que la concentration du dopage n de la couche active (3) est de $10^{16}$ à $10^{17}$ $cm^{-3}$ et que la concentration du dopage p de la couche intermédiaire (30) est supérieure à $10^{17}$, enfin que la concentration du dopage n de la couche (40) de type opposé à celui de la couche active est supérieure à $10^{18}$ $cm^{-3}$.

9. Cellule photovoltaïque selon la revendication 7, caractérisée en ce que la couche (40) de type n supporte une couche (41) de GaAs surmontée d'une couche métallique (42), l'ensemble de ces deux couches étant évidé de manière à laisser passer la lumière.

10. Cellule photovoltaïque selon la revendication 7, caractérisée en ce que le paramètre y varie progressivement dans l'épaisseur de la couche de type n.

11. Cellule photovoltaïque selon l'une quelconque des revendications 1 à 4, caractérisée en ce que la couche active étant en GaAs de type n, la couche intermédiaire est constituée par un composé de Ga, In, As et P.

12. Cellule photovoltaïque selon l'une quelconque des revendications 1 à 5, caractérisée en ce que la couche active étant en GaAs de type p, la couche de type n et la couche intermédiaire sont constituées par des composés de Ga, In, As et P.

13. Cellule photovoltaïque selon l'une des revendications 1 à 5, caractérisée en ce que la couche active étant en InP, la couche intermédiaire est constituée par un composé de In, P, Cd et S.

FIG.1

FIG.3

GaAs (n)

(GaAlAs)

Ge(n)

Mo

42
41 (GaAs)
40 (GaAlAs)

n

GaAs(p)

FIG.4

30 (GaAlAs)

Ge(p)

Mo

# FIG.2